(19) Europäisches Patentamt / European Patent Office / Office européen des brevets

(11) EP 3 220 432 A1

(12) **EUROPEAN PATENT APPLICATION**
published in accordance with Art. 153(4) EPC

(43) Date of publication:
**20.09.2017 Bulletin 2017/38**

(21) Application number: **15859067.9**

(22) Date of filing: **16.10.2015**

(51) Int Cl.:
***H01L 41/193*** *(2006.01)*
***B29C 55/04*** *(2006.01)*
***H01L 41/083*** *(2006.01)*
***H01L 41/27*** *(2013.01)*
***H01L 41/45*** *(2013.01)*

(86) International application number:
**PCT/JP2015/079338**

(87) International publication number:
**WO 2016/076071 (19.05.2016 Gazette 2016/20)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: **14.11.2014 JP 2014231857**

(71) Applicant: **Mitsui Chemicals, Inc.**
**Minato-ku**
**Tokyo 105-7122 (JP)**

(72) Inventors:
- **SATO, Keisuke**
  **Nagoya-shi**
  **Aichi 457-8522 (JP)**
- **TANIMOTO, Kazuhiro**
  **Nagoya-shi**
  **Aichi 457-8522 (JP)**
- **OTA, Koji**
  **Nagoya-shi**
  **Aichi 457-8522 (JP)**
- **OZAKI, Katsutoshi**
  **Nagoya-shi**
  **Aichi 457-8522 (JP)**
- **ONISHI, Katsuki**
  **Nagoya-shi**
  **Aichi 457-8522 (JP)**

(74) Representative: **Hoffmann Eitle**
**Patent- und Rechtsanwälte PartmbB**
**Arabellastraße 30**
**81925 München (DE)**

(54) **PIEZOELECTRIC POLYMER FILM**

(57) A polymeric piezoelectric film including an optically active helical chiral polymer (A) having a weight average molecular weight of from 50,000 to 1,000,000, wherein: a crystallinity obtained by a DSC method is from 20% to 80%; a standardized molecular orientation MORc measured by a microwave transmission-type molecular orientation meter based on a reference thickness of 50 μm is from 3.5 to 15.0; and in a waveform measured with an inline film thickness meter and representing a relationship between a position in a width direction on the film and a thickness of the film, a number of peaks A is 20 or less per 1,000 mm of a film width, wherein the peaks A have a peak height of 1.5 μm or more and a peak slope of 0.000035 or more.

FIG.1

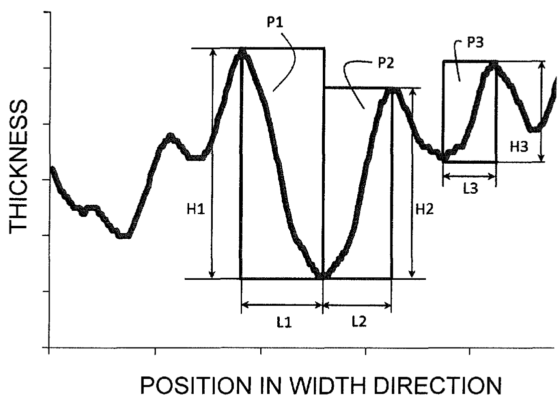


EP 3 220 432 A1

## Description

TECHNICAL FIELD

The present invention relates to a polymeric piezoelectric film.

BACKGROUND ART

PZT ($PbZrO_3$-$PbTiO_3$-based solid solution) which is a ceramic material is conventionally used for a piezoelectric material in many cases. Since PZT contains lead, however, a polymeric piezoelectric material whose environmental load is low and which is flexible is increasingly used as a piezoelectric material.

Examples of a known polymeric piezoelectric material include a Poling-type polymer represented by nylon 11, polyvinyl fluoride, polyvinyl chloride, or polyurea, and a ferroelectric polymer represented by polyvinylidene fluoride (β-type) (PVDF), or vinylidene fluoride-trifluoro ethylene copolymer (P(VDF-TrFE)) (75/25).

In recent years, use of an optically active aliphatic polyester, such as polylactic acid, has drawn attention in addition to the above polymeric piezoelectric materials. Polylactic acid-based polymer is known to exhibit the piezoelectricity only by a mechanical stretching operation.

Among optically active polymers, the piezoelectricity of a polymer crystal, such as polylactic acid-based polymer, results from permanent dipoles of C=O bonds existing in the helical axis direction. Especially, a polylactic acid-based polymer, in which the volume fraction of side chains with respect to a main chain is small and the content of permanent dipoles per volume is large, is said to constitute an ideal polymer among polymers having helical chirality.

Polylactic acid-based polymer exhibiting piezoelectricity only by a stretching treatment does not require a poling treatment and is known to maintain the piezoelectric modulus without decrease for several years.

Since polylactic acid-based polymer exhibits a variety of piezoelectric properties as described above, a variety of polymeric piezoelectric materials using polylactic acid have been reported (see, for example, Documents 1 to 4).

Document 1: Japanese Patent Application Laid-Open (JP-A) No. H05-152638
Document 2: JP-A No. 2005-213376
Document 3: JP-A No. 2014-086703
Document 4 JP-A No. 2014-027055

SUMMARY OF INVENTION

TECHNICAL PROBLEM

Incidentally, in order for the aforementioned polymeric piezoelectric material to exhibit piezoelectricity, molecular chains need to be oriented in at least one direction. For example, in the case of a uniaxially stretched film which is longitudinally stretched as described in Document 3, thickness unevenness has tended to be generated in a direction perpendicular to the stretching direction (a direction in which molecular chains are orientated) and parallel to the principal plane of the film. Since a biaxially stretched film of a general polyethylene terephthalate or a helical chiral polymer which does not exhibit piezoelectricity is stretched at about the same magnification in the longitudinal direction and in the transverse direction, thickness unevenness is likely to be alleviated. However, when thickness unevenness occurs, waviness occurs on the surface of a film, whereby the appearance thereof is likely to be deteriorated. For this reason, reduction in thickness unevenness may be demanded.

Meanwhile, Document 4 proposes that, in a layered body formed by layering a plurality of films stretched in an oblique direction with respect to a film forming direction, thickness unevenness and variation of the piezoelectricity of the layered body are reduced even when a plurality of films are formed under the same conditions.

According to studies by the present inventors, however, even when thickness unevenness on the same film surface is reduced in a single layer film, there has been a tendency that variation of the piezoelectricity of the single layer film is not necessarily reduced.

Accordingly, it is an object of the present invention to provide a polymeric piezoelectric film in which thickness unevenness of the polymeric piezoelectric film is reduced and variation of the piezoelectricity is reduced.

SOLUTION TO PROBLEM

Specific means for achieving the object are, for example, as follow.

[1] A polymeric piezoelectric film comprising an optically active helical chiral polymer (A) having a weight average

molecular weight of from 50,000 to 1,000,000, wherein:

a crystallinity obtained by a DSC method is from 20% to 80%;
a standardized molecular orientation MORc measured by a microwave transmission-type molecular orientation meter based on a reference thickness of 50 μm is from 3.5 to 15.0; and
in a waveform measured with an inline film thickness meter and representing a relationship between a position in a width direction on the film and a thickness of the film, a number of peaks A is 20 or less per 1,000 mm of a film width, wherein the peaks A have a peak height of 1.5 μm or more and a peak slope of 0.000035 or more.

[2] The polymeric piezoelectric film according to [1], wherein in the waveform measured with the inline film thickness meter and representing the relationship between a position in the width direction on the film and a thickness of the film, a number of peaks B is 12 or less per 1,000 mm of the film width, wherein the peaks B have a peak height of 1.5 μm or more and a peak slope of 0.00008 or more.
[3] The polymeric piezoelectric film according to [1] or [2], wherein an internal haze with respect to visible light is 50% or less, and a piezoelectric constant $d_{14}$ measured by a stress-electric charge method at 25°C is 1 pC/N or more.
[4] The polymeric piezoelectric film according to any one of [1] to [3], wherein an internal haze with respect to visible light is 13% or less.
[5] The polymeric piezoelectric film according to any one of [1] to [4], wherein the helical chiral polymer (A) is a polylactic acid-based polymer having a main chain comprising a repeating unit represented by the following Formula (1):

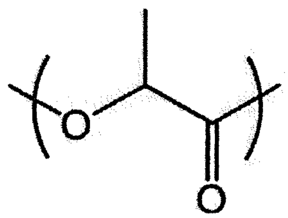

(1)

.

[6] The polymeric piezoelectric film according to any one of [1] to [5], wherein a content of the helical chiral polymer (A) is 80% by mass or more.
[7] The polymeric piezoelectric film according to any one of [1] to [6], wherein a product of the standardized molecular orientation MORc and the crystallinity is from 40 to 700.
[8] The polymeric piezoelectric film according to any one of [1] to [7], wherein an internal haze with respect to visible light is 1.0% or less.
[9] The polymeric piezoelectric film according to any one of [1] to [8], comprising from 0.01 parts by mass to 10 parts by mass of a stabilizer (B) with respect to 100 parts by mass of the helical chiral polymer (A), the stabilizer (B) having a weight average molecular weight of from 200 to 60,000 and having one or more functional groups selected from the group consisting of a carbodiimide group, an epoxy group, and an isocyanate group.
[10] The polymeric piezoelectric film according to any one of [1] to [9], wherein the number of the peaks A is 15 or less per 1,000 mm of the film width.
[11] The polymeric piezoelectric film according to any one of [1] to [10], wherein the number of the peaks A is 10 or less per 1,000 mm of the film width.
[12] The polymeric piezoelectric film according to any one of [1] to [11], wherein the number of the peaks B is 10 or less per 1,000 mm of the film width.
[13] The polymeric piezoelectric film according to any one of [1] to [12], wherein the number of the peaks B is eight or less per 1,000 mm of the film width.

ADVANTAGEOUS EFFECTS OF INVENTION

According to the present invention, a polymeric piezoelectric film can be provided in which thickness unevenness of the polymeric piezoelectric film is reduced and variation of the piezoelectricity is reduced.

BRIEF DESCRIPTION OF DRAWING

Fig. 1 is a drawing illustrating one example of a waveform representing a relationship between a position in the width direction on a polymeric piezoelectric film and a thickness of the polymeric piezoelectric film according to the present embodiment.

DESCRIPTION OF EMBODIMENTS

An embodiment which is one example of the present invention will be described below.
Here, a numerical range represented using "to" means a range including numerical values described before and after "to" as a lower limit value and an upper limit value, respectively.
Here, a "film" is a concept encompassing a so-called "sheet" as well as a so-called "film".

<Polymeric Piezoelectric Film>

A polymeric piezoelectric film of the present embodiment is a polymeric piezoelectric film comprising an optically active helical chiral polymer (A) having a weight average molecular weight of from 50,000 to 1,000,000, wherein the crystallinity obtained by a DSC method is from 20% to 80%, and a standardized molecular orientation MORc measured by a microwave transmission-type molecular orientation meter based on a reference thickness of 50 μm is from 3.5 to 15.0.
Further, in a waveform representing the relationship between a position in the width direction on the film and a thickness of the film measured with an inline film thickness meter, the number of peaks A is 20 or less per 1,000 mm of the film width.
Here, peak A is a peak in which the peak height is 1.5 μm or more, and the peak slope is 0.000035 or more. The peak slope is a value obtained by dividing the peak height by a peak-to-peak distance, and is represented by an absolute value. The peak will be described later in detail.
Uniaxial stretching of a polymeric piezoelectric film tends to cause thickness unevenness. When thickness unevenness occurs, waviness occurs on the surface of the film due to thickness unevenness, and there arises a problem that the appearance (visual observation, under cross-Nicol, or the like) deteriorates, for example, when applied to a device or the like. Therefore, there are cases where improvements in appearance problems are demanded.
By reducing the thickness unevenness of the film, it is considered that the occurrence of waviness is suppressed, and it is thus considered that the appearance problem is improved. However, even when a film is made such that, in order to improve thickness unevenness, numerical values of a standard deviation of thickness, and a ratio (hereinafter, also referred to as a thickness R%) obtained by dividing the difference between the maximum thickness and the minimum thickness by the average thickness, which are an index representing thickness unevenness, are decreased, the appearance problems were not sufficiently improved. Further, according to studies by the present inventors, it was difficult to sufficiently suppress variation of the piezoelectricity.
The standard deviation of the thickness and the thickness R% are average information of the entire thickness of a film and it is difficult to reduce the appearance problem and variation of the piezoelectricity simply by suppressing such numerical values low. It is therefore presumed that waviness is caused by an abrupt thickness change of the film.
Accordingly, the present inventors intensively studied and focused on the height of a peak of the thickness and the slope of the peak in order to suppress an abrupt change in the thickness which is considered to generate waviness and variation of the piezoelectricity. The present inventors then found that, by manufacturing a film such that the peak of the thickness satisfies a specific condition, a polymeric piezoelectric film in which thickness unevenness of the polymeric piezoelectric film is reduced, appearance problems are improved, and variation of the piezoelectricity is reduced is obtained, thereby completing the present invention.
In other words, in a polymeric piezoelectric film according to the present embodiment, by employing the above configuration, a polymeric piezoelectric film in which thickness unevenness is decreased and variation of the piezoelectricity is decreased can be provided.

[Optically Active Helical Chiral Polymer (A)]

A polymeric piezoelectric film comprises an optically active helical chiral polymer (A).
The helical chiral polymer (A) is a helical chiral polymer whose weight average molecular weight is from 50,000 to 1,000,000 and which is optically active.
Here, the term "optically active helical chiral polymer" refers to a polymer whose molecular structure is a helical structure and which is molecularly optically active.
The helical chiral polymer (A) is a polymer whose weight average molecular weight is from 50,000 to 1,000,000 among the above "optically active helical chiral polymer".
Examples of the helical chiral polymer (A) include polypeptide, a cellulose derivative, a polylactic acid-based polymer, polypropylene oxide, and poly(β-hydroxybutyric acid).
Examples of the polypeptide include poly(γ-benzyl glutarate), and poly(γ-methyl glutarate).
Examples of the cellulose derivative include cellulose acetate, and cyanoethyl cellulose.
The optical purity of the helical chiral polymer (A) is preferably 95.00%ee or more, more preferably 96.00%ee or more, further preferably 99.00%ee or more, and still further preferably 99.99%ee or more from a viewpoint of enhancing

the piezoelectricity of a polymeric piezoelectric film. Particularly preferably, the optical purity of the helical chiral polymer (A) is 100.00%ee. It is presumed that, by selecting the optical purity of the helical chiral polymer (A) in the above range, packing property of a polymer crystal exhibiting piezoelectricity is improved and as the result the piezoelectricity is improved.

Herein, the optical purity of the helical chiral polymer (A) is a value calculated according to the following formula.

$$\text{Optical purity (\%ee)} = 100 \times |\text{L-form amount - D-form amount}| / (\text{L-form amount + D-form amount})$$

That is, the optical purity of the helical chiral polymer (A) is a value obtained by multiplying 'the value obtained by dividing "the amount difference (absolute value) between the amount [% by mass] of helical chiral polymer (A) in L-form and the amount [% by mass] of helical chiral polymer (A) in D-form" by "the total amount of the amount [% by mass] of helical chiral polymer (A) in L-form and the amount [% by mass] of helical chiral polymer (A) in D-form"' by '100'.

For the amount [% by mass] of helical chiral polymer (A) in L-form and the amount [% by mass] of helical chiral polymer (A) in D-form, values obtained by a method using a high performance liquid chromatography (HPLC) are used. Detail of the measurement will be described later.

For the above helical chiral polymer (A), a polymer having a main chain including a repeating unit represented by the following Formula (1) is preferable from a viewpoint of increasing the optical purity and improving the piezoelectricity.

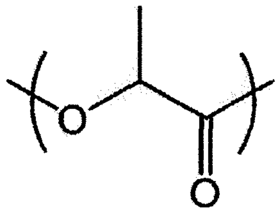

(1)

Examples of the polymer having a main chain including a repeating unit represented by the Formula (1) include a polylactic acid-based polymer.

Here, the term "polylactic acid-based polymer" refers to "polylactic acid (a polymer consisting of repeating units derived from a monomer selected from L-lactic acid or D-lactic acid)", "a copolymer of L-lactic acid or D-lactic acid and a compound copolymerizable with the L-lactic acid or D-lactic acid", or a mixture thereof.

Among polylactic acid-based polymers, a polylactic acid is preferable, and a homopolymer (PLLA) of L-lactic acid or a homopolymer (PDLA) of D-lactic acid is most preferable.

Polylactic acid is a polymer which is obtained by polymerizing lactic acid via ester bond to be connected and elongated.

Polylactic acid is known to be manufactured by: a lactide method involving lactide; a direct polymerization method in which lactic acid is heated in a solvent under a reduced pressure to be polymerized while removing water; or the like.

Examples of the polylactic acid include a homopolymer of L-lactic acid, a homopolymer of D-lactic acid, a block copolymer including a polymer of at least one of L-lactic acid or D-lactic acid, and a graft copolymer including a polymer of at least one of L-lactic acid or D-lactic acid.

Examples of the above "compound copolymerizable with the L-lactic acid or D-lactic acid" include a hydroxycarboxylic acid, such as glycolic acid, dimethylglycolic acid, 3-hydroxybutyric acid, 4-hydroxybutyric acid, 2-hydroxypropanoic acid, 3-hydroxypropanoic acid, 2-hydroxyvaleric acid, 3-hydroxyvaleric acid, 4-hydroxyvaleric acid, 5-hydroxyvaleric acid, 2-hydroxycaproic acid, 3-hydroxycaproic acid, 4-hydroxycaproic acid, 5-hydroxycaproic acid, 6-hydroxycaproic acid, 6-hydroxymethylcaproic acid, and mandelic acid; a cyclic ester, such as glycolide, β-methyl-δ-valerolactone, γ-valerolactone, and ε-caprolactone; a polycarboxylic acid, such as oxalic acid, malonic acid, succinic acid, glutaric acid, adipic acid, pimelic acid, azelaic acid, sebacic acid, undecanedioic acid, dodecanedioic acid, and terephthalic acid, and an anhydride of such a polycarboxylic acid; a polyhydric alcohol, such as ethylene glycol, diethylene glycol, triethylene glycol, 1,2-propanediol, 1,3-propanediol, 1,3-butanediol, 1,4-butanediol, 2,3-butanediol, 1,5-pentanediol, 1,6-hexanediol, 1,9-nonanediol, 3-methyl-1,5-pentanediol, neopentylglycol, tetramethylene glycol, and 1,4-hexanedimethanol; a polysaccharide such as cellulose; and an aminocarboxylic acid such as α-amino acid.

Examples of the "a copolymer of L-lactic acid or D-lactic acid and a compound copolymerizable with the L-lactic acid or the D-lactic acid" include a block copolymer or a graft copolymer having a polylactic acid sequence capable of generating a helical crystal.

The concentration of a structure derived from a copolymer component in helical chiral polymer (A) is preferably

20 mol% or less.

For example, when the helical chiral polymer (A) is a polylactic acid-based polymer, the concentration of a structure derived from a copolymer component with respect to the total number of moles of a structure derived from lactic acid and a structure derived from a compound (copolymer component) copolymerizable with lactic acid in the polylactic acid-based polymer is preferably 20 mol% or less.

A polylactic acid-based polymer can be manufactured by: a method of obtaining a polylactic acid by direct dehydration condensation of lactic acid as described in JP-A No. S59-096123 and JP-A No. H07-033861; a method of ring-opening polymerization using lactide which is a cyclic dimer of lactic acid as described in U.S. Patent No. 2,668,182, U.S. Patent No. 4,057,357, and the like; or the like.

In order to make the optical purity of a polylactic acid-based polymer obtained by each of the above manufacturing methods 95.00%ee or more, for example, when polylactic acid is manufactured by a lactide method, it is preferable to polymerize lactide whose optical purity is enhanced to 95.00%ee or more by a crystallization operation.

(Weight Average Molecular Weight)

The weight average molecular weight (Mw) of helical chiral polymer (A) is from 50,000 to 1,000,000 as described above.

Since the Mw of helical chiral polymer (A) is 50,000 or more, the mechanical strength of a polymeric piezoelectric film is improved. The Mw is preferably 100,000 or more, and more preferably 200,000 or more.

On the other hand, since the Mw of helical chiral polymer (A) is 1,000,000 or less, moldability when a polymeric piezoelectric film is obtained by molding (for example, extrusion molding) is improved. The Mw is preferably 800,000 or less, and more preferably 300,000 or less.

The molecular weight distribution (Mw/Mn) of the helical chiral polymer (A) is preferably from 1.1 to 5, and more preferably from 1.2 to 4 from a viewpoint of the strength of the polymeric piezoelectric film. The molecular weight distribution is still more preferably from 1.4 to 3.

The weight average molecular weight (Mw) and the molecular weight distribution (Mw/Mn) of the helical chiral polymer (A) are values measured by the following GPC measurement method using a gel permeation chromatograph (GPC). Here, Mn is the number average molecular weight of the helical chiral polymer (A).

- GPC Measurement Apparatus -

GPC-100 manufactured by Waters Corp.

- Column -

Shodex LF-804 manufactured by Showa Denko K.K.

- Preparation of Sample -

The helical chiral polymer (A) is dissolved in a solvent (for example, chloroform) at 40°C to prepare a sample solution having a concentration of 1 mg/mL.

- Measurement Condition -

0.1 mL of the sample solution is introduced into a column at a temperature of 40°C and a flow rate of 1 mL/min by using chloroform as a solvent.

The sample concentration in the sample solution separated by the column is measured by a differential refractometer. A universal calibration curve is created based on a polystyrene standard sample. The weight average molecular weight (Mw) and the molecular weight distribution (Mw/Mn) of the helical chiral polymer (A) are calculated.

For the polylactic acid-based polymer which is an example of the helical chiral polymer (A), a commercially available polylactic acid may be used.

Examples of the commercially available polylactic acid include PURASORB (PD, PL) manufactured by Purac Inc., LACEA (H-100, H-400) manufactured by Mitsui Chemicals, Inc., and Ingeo™ biopolymer manufactured by NatureWorks LLC.

When a polylactic acid-based polymer is used as the helical chiral polymer (A), it is preferable to manufacture the polylactic acid-based polymer by a lactide method or a direct polymerization method in order to make the weight average molecular weight (Mw) of the polylactic acid-based polymer 50,000 or more.

The polymeric piezoelectric film may contain only one type of the above helical chiral polymer (A), or two or

more types of the above helical chiral polymers (A).

From a viewpoint of further increasing the piezoelectric constant, the content (total content when two or more types of the helical chiral polymers (A) are used) of the helical chiral polymer (A) in the polymeric piezoelectric film is preferably 80% by mass or more with respect to the total amount of the polymeric piezoelectric film.

[Stabilizer (B)]

A polymeric piezoelectric film preferably further includes a stabilizer (B) which has, in one molecule, one or more functional groups selected from the group consisting of a carbodiimide group, an epoxy group, and an isocyanate group, and has a weight average molecular weight of from 200 to 60,000. This makes it possible to further improve the moist heat resistance.

For the stabilizer (B), it is possible to use "stabilizer (B)" described in paragraphs 0039 to 0055 of WO 2013/054918 A.

Examples of a compound having, in one molecule, a carbodiimide group (carbodiimide compound) which can be used as the stabilizer (B) include a monocarbodiimide compound, a polycarbodiimide compound, and a cyclic carbodiimide compound.

For the monocarbodiimide compound, dicyclohexylcarbodiimide, bis-2,6-diisopropylphenylcarbodiimide, or the like is suitable.

As the polycarbodiimide compound, polycarbodiimide compounds manufactured by various methods can be used. Polycarbodiimide compounds manufactured by conventional methods of manufacturing a polycarbodiimide (for example, U.S. Patent No. 2941956, Japanese Patent Publication (JP-B) No. S47-33279, J. Org. Chem. 28, 2069-2075 (1963), Chemical Review 1981, Vol. 81, No. 4, p619-621) can be used. Specifically, a carbodiimide compound described in Japanese Patent No. 4084953 can be also used.

Examples of the polycarbodiimide compound include poly(4,4'-dicyclohexylmethanecarbodiimide), poly(N,N'-di-2,6-diisopropylphenylcarbodiimide), and poly(1,3,5-triisopropylphenylene-2,4-carbodiimide.

The cyclic carbodiimide compound can be synthesized based on a method described in JP-A No. 2011-256337, or the like.

As the carbodiimide compound, a commercially available product may be used. Examples thereof include B2756 (trade name) manufactured by Tokyo Chemical Industry Co., Ltd., CARBODILITE LA-1 (trade name) manufactured by Nisshinbo Chemical Inc., and Stabaxol P, Stabaxol P400, and Stabaxol I (all are trade names) manufactured by Rhein Chemie GmbH.

Examples of a compound having, in one molecule, an isocyanate group (isocyanate compound) which can be used as the stabilizer (B) include 3-(triethoxysilyl)propyl isocyanate, 2,4-tolylene diisocyanate, 2,6-tolylene diisocyanate, m-phenylene diisocyanate, p-phenylene diisocyanate, 4,4'-diphenylmethane diisocyanate, 2,4'-diphenylmethane diisocyanate, 2,2'-diphenylmethane diisocyanate, xylylene diisocyanate, hydrogenated xylylene diisocyanate, and isophorone diisocyanate.

Examples of a compound having, in one molecule, an epoxy group (epoxy compound) which can be used as the stabilizer (B) include phenyl glycidyl ether, diethyleneglycol diglycidyl ether, bisphenol A-diglycidyl ether, hydrogenated bisphenol A-diglycidyl ether, a phenol novolac-type epoxy resin, a cresol novolac-type epoxy resin, and epoxidized polybutadiene.

The weight average molecular weight of the stabilizer (B) is from 200 to 60,000 as described above, more preferably from 250 to 30,000, and still more preferably from 300 to 18,000.

When the molecular weight is within the above range, the stabilizer (B) moves more easily, and an effect of improving the moist heat resistance is exhibited more effectively.

The weight average molecular weight of the stabilizer (B) is particularly preferably from 200 to 900. The weight average molecular weight of from 200 to 900 nearly corresponds to the number average molecular weight of from 200 to 900. When the weight average molecular weight is from 200 to 900, the molecular weight distribution is 1.0 in some cases. In such cases, "weight average molecular weight of from 200 to 900" can be simply paraphrased as "molecular weight of from 200 to 900".

When a polymeric piezoelectric film contains the stabilizer (B), the above polymeric piezoelectric film may contain only one type of stabilizer, or may contain two or more types of stabilizers.

When a polymeric piezoelectric film contains the stabilizer (B), the content of the stabilizer (B) is, with respect to 100 parts by mass of helical chiral polymer (A), preferably from 0.01 parts by mass to 10 parts by mass, more preferably from 0.01 parts by mass to 5 parts by mass, further preferably from 0.1 parts by mass to 3 parts by mass, and particularly preferably from 0.5 parts by mass to 2 parts by mass.

When the above content is 0.01 parts by mass or more, the moist heat resistance is further improved.

When the above content is 10 parts by mass or less, deterioration of the transparency is further suppressed.

Examples of a preferable mode of the stabilizer (B) include a mode in which a stabilizer (B1) which has one or

more kinds of functional groups selected from the group consisting of a carbodiimide group, an epoxy group, and an isocyanate group, and has a number average molecular weight of from 200 to 900, and a stabilizer (B2) which has, in one molecule, two or more functional groups of one or more kinds selected from the group consisting of a carbodiimide group, an epoxy group, and an isocyanate group, and has a weight average molecular weight of from 1,000 to 60,000 are used in combination. The weight average molecular weight of the stabilizer (B1) having a number average molecular weight of from 200 to 900 is about from 200 to 900. The number average molecular weight and the weight average molecular weight of the stabilizer (B1) have almost the same values.

When the stabilizer (B1) and the stabilizer (B2) are used in combination as the stabilizer, the stabilizer preferably includes a larger amount of the stabilizer (B1) from a viewpoint of improving transparency.

Specifically, with respect to 100 parts by mass of the stabilizer (B1), the amount of the stabilizer (B2) is preferably in a range of from 10 parts by mass to 150 parts by mass, and more preferably in a range of from 50 parts by mass to 100 parts by mass from a viewpoint of coexistence of transparency and moist heat resistance.

Specific examples (stabilizers B-1 to B-3) of the stabilizer (B) will be described below.

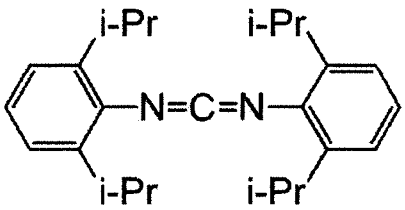

B-1

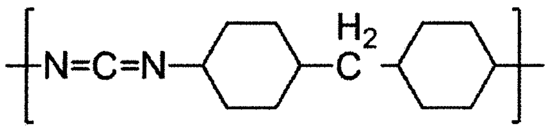

B-2

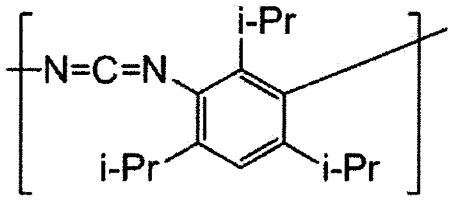

B-3

Regarding the above stabilizers B-1 to B-3, the name of the compound, a commercially available product, and the like are described below.

- Stabilizer B-1 ··· The name of the compound is bis-2,6-diisopropylphenylcarbodiimide. The weight average molecular weight (in this example, simply equivalent to "molecular weight") is 363. Examples of the commercially available product include "Stabaxol I" manufactured by Rhein Chemie GmbH and "B2756" manufactured by Tokyo Chemical Industry Co., Ltd.
- Stabilizer B-2 ··· The name of the compound is poly(4,4'-dicyclohexylmethanecarbodiimide). Examples of the commercially available product include "carbodilite LA-1" manufactured by Nisshinbo Chemical Inc. as one having a weight average molecular weight of about 2,000.
- Stabilizer B-3 ··· The name of the compound is poly(1,3,5-triisopropylphenylene-2,4-carbodiimide). Examples of the commercially available product include "Stabaxol P" manufactured by Rhein Chemie GmbH as one having a weight average molecular weight of about 3,000. Examples of those having a weight average molecular weight of 20,000 include "Stabaxol P400" manufactured by Rhein Chemie GmbH.

[Other Components]

The polymeric piezoelectric film may optionally contain other components.

Examples of the other components include a known resin, such as polyvinylidene fluoride, a polyethylene resin, or a polystyrene resin; a known inorganic filler, such as silica, hydroxy apatite, or montmorillonite; a known nucleating agent, such as phthalocyanine; and a stabilizer other than the stabilizer (B).

Examples of the inorganic filler and nucleating agent include components described in paragraphs 0057 to

0058 of WO 2013/054918.

[Physical Properties of Polymeric Piezoelectric Film]

A polymeric piezoelectric film preferably has a large piezoelectric constant (preferably, the piezoelectric constant $d_{14}$ measured at 25°C by a stress-electric charge method is 1 pC/N or more). Further, a polymeric piezoelectric film preferably has excellent transparency and longitudinal tear strength (i.e., tear strength with respect to the specific direction, the same applies below).

[Piezoelectric Constant (Stress-Electric Charge Method)]

The piezoelectric constant of a polymeric piezoelectric film is a value measured according to the following.

First, a polymeric piezoelectric film is cut into a size of 150 mm in the direction of 45° with respect to the stretching direction (for example, MD direction) of the polymeric piezoelectric film, and 50 mm in the direction perpendicular to the above 45° direction, to prepare a rectangular specimen. Subsequently, the prepared specimen is set on a stage of Showa Shinku SIP-600, and Al is deposited on one surface of the specimen such that the deposition thickness of Al becomes about 50 nm. Subsequently, Al is deposited on the other surface of the specimen similarly. Accordingly, conductive layers of Al are formed on both surfaces of the specimen.

The specimen (polymeric piezoelectric film) of 150 mm × 50 mm having the Al conductive layers formed on both surfaces is cut into a size of 120 mm in the direction of 45° with respect to the stretching direction (for example, MD direction) of the polymeric piezoelectric film, and 10 mm in the direction perpendicular to the above 45° direction, so as to cut out a rectangular film of 120 mm × 10 mm. This film is used as a sample for measuring a piezoelectric constant.

The sample thus obtained is set in a tensile testing machine (TENSILON RTG-1250 manufactured by A&D Company, Limited) having a distance between chucks of 70 mm so as not to be slack. A force is applied periodically at a crosshead speed of 5 mm/min such that the applied force reciprocates between 4 N and 9 N. In order to measure a charge amount generated in the sample according to the applied force at this time, a capacitor having an electrostatic capacity Qm (F) is connected in parallel to the sample, and a voltage Vm between the terminals of this capacitor Cm (95 nF) is measured through a buffer amplifier. A generated charge amount Q (C) is calculated as a product of the capacitor capacity Cm and a voltage Vm between the terminals. The piezoelectric constant $d_{14}$ is calculated by the following formula.

$$d_{14} = (2 \times t)/L \times Cm \bullet \Delta Vm/\Delta F$$

t: sample thickness (m)
L: distance between chucks (m)
Cm: capacity (F) of capacitor connected in parallel
$\Delta Vm/\Delta F$: ratio of change amount of voltage between terminals of capacitor with respect to change amount of force

A higher piezoelectric constant results in a larger displacement of the polymeric piezoelectric film with respect to a voltage applied to the film, but results in a higher voltage generated responding to a force applied to the polymeric piezoelectric film, and therefore is advantageous as a polymeric piezoelectric film.

Specifically, the piezoelectric constant $d_{14}$ measured at 25°C by a stress-electric charge method is preferably I pC/N or more, more preferably 3 pC/N or more, and further preferably 4 pC/N or more. The upper limit of the piezoelectric constant is not particularly limited, and is preferably 50 pC/N or less, and more preferably 30 pC/N or less, for a polymeric piezoelectric film using an optically active helical chiral polymer (optically active polymer) from a viewpoint of a balance with transparency, or the like described below.

Similarly, from a viewpoint of the balance with transparency, the piezoelectric constant $d_{14}$ measured by a resonance method is preferably 15 pC/N or less.

Herein, the "MD direction" refers to a direction (Machine Direction) in which a film flows, that is, a stretching direction, and the "TD direction" refers to a direction (Transverse Direction) which is perpendicular to the MD direction and parallel to a principal plane of the film.

Further, herein, the principal plane of a film means the surface having the largest area among surfaces of a polymeric piezoelectric film.

[Transparency (Internal Haze)]

Transparency of a polymeric piezoelectric film can be evaluated by measurement of internal haze.

The internal haze of the polymeric piezoelectric film with respect to visible light is preferably 50% or less, more preferably 40% or less, further preferably 20% or less, still further preferably 13% or less, and still further preferably 5% or less. From a viewpoint of further improving transparency and longitudinal tear strength, the internal haze of the polymeric piezoelectric film with respect to visible light is further preferably 2.0% or less, and particularly preferably 1.0% or less. The lower limit of the internal haze of a polymeric piezoelectric film is not particularly limited, and examples of the lower limit include 0.01%.

Herein, the internal haze of a polymeric piezoelectric film refers to a haze excluding a haze due to the shape of the outer surface of the polymeric piezoelectric film.

Here, the internal haze a polymeric piezoelectric film is a value obtained when a haze of a polymeric piezoelectric film having a thickness of from 0.03 mm to 0.05 mm is measured in accordance with JIS-K7105 using a haze measuring machine [TC-HIII DPK manufactured by Tokyo Denshoku Co., Ltd.,] at 25°C. Details of the measurement method will be described in the Examples.

[Standardized Molecular Orientation MORc]

Standardized molecular orientation MORc is a value determined based on "molecular orientation ratio MOR" which is an index representing the degree of orientation of a helical chiral polymer (A).

Herein, the molecular orientation ratio MOR (Molecular Orientation Ratio) is measured by the following microwave measurement method. That is, a polymeric piezoelectric film (for example, a polymeric piezoelectric material in a film shape) is placed in a microwave resonant waveguide of a well known microwave transmission-type molecular orientation meter (also referred to as microwave molecular orientation ratio measurement apparatus) such that the surface of the polymeric piezoelectric film (film surface) is perpendicular to a traveling direction of the microwaves. Then, while the sample is continuously irradiated with microwaves an oscillating direction of which is biased unidirectionally, the polymeric piezoelectric film is rotated in a plane perpendicular to the traveling direction of the microwaves from 0 to 360°, and the intensity of the microwaves which have passed through the sample is measured to determine the molecular orientation ratio MOR.

The standardized molecular orientation MORc is a molecular orientation ratio MOR obtained based on the reference thickness tc of 50 μm, and can be determined by the following formula.

$$MORc = (tc/t) \times (MOR - 1) + 1$$

(tc: reference thickness for correction; t: thickness of polymeric piezoelectric film)

The standardized molecular orientation MORc can be measured by a publicly known molecular orientation meter, for example, a microwave molecular orientation meter MOA-2012A or MOA-6000 manufactured by Oji Scientific Instruments, at a resonance frequency around 4 GHz or 12 GHz.

The standardized molecular orientation MORc of a polymeric piezoelectric film is from 3.5 to 15.0, and is preferably from 4.0 to 15.0, more preferably from 4.0 to 10.0, and further preferably from 4.0 to 8.0.

When the standardized molecular orientation MORc is 3.5 or more, there are many molecular chains (for example, polylactic acid molecular chains) of optically active polymers aligned in the stretching direction, and as a result, the rate of oriented crystals generated increases, thereby exhibiting higher piezoelectricity.

When the standardized molecular orientation MORc is 15.0 or less, the longitudinal tear strength further increases.

From a viewpoint of further improving adherence between a polymeric piezoelectric film and an intermediate layer, the standardized molecular orientation MORc is preferably 7.0 or less.

When the polymeric piezoelectric film is, for example, a stretched film, the standardized molecular orientation MORc can be controlled by heat treatment conditions (heating temperature and heating time) before stretching, stretching conditions (stretching temperature and stretching speed), or the like.

The standardized molecular orientation MORc can be converted to birefringence Δn which is obtained by dividing retardation by a film thickness. Specifically, the retardation can be measured by a RETS100 manufactured by Otsuka Electronics Co., Ltd. MORc and Δn are approximately in a linearly proportional relationship. When Δn is 0, MORc is 1.

For example, when the helical chiral polymer (A) is a polylactic acid-based polymer and the birefringence Δn of the polymeric piezoelectric film is measured at measurement wavelength of 550 nm, the lower limit 2.0 of a preferable

range for the standardized molecular orientation MORc can be converted to the birefringence Δn of 0.005. The lower limit 40 of a preferable range of a product of the standardized molecular orientation MORc and the crystallinity of the polymeric piezoelectric film as described below can be converted to 0.1 as a product of the birefringence Δn and the crystallinity of the polymeric piezoelectric film.

[Crystallinity]

The crystallinity of a polymeric piezoelectric film is determined by a DSC method.

The crystallinity of the polymeric piezoelectric film according to the present embodiment is from 20% to 80%. When the crystallinity is 20% or more, the piezoelectricity of the polymeric piezoelectric film is maintained high. When the crystallinity is 80% or less, the transparency of the polymeric piezoelectric film is maintained high; and when the crystallinity is 80% or less, since whitening or a break is less likely to occur during stretching, the polymeric piezoelectric film can be manufactured easily.

Therefore, the crystallinity of the polymeric piezoelectric film is from 20% to 80%, and is preferably from 25% to 70%, and more preferably from 30% to 50%.

[Product of Standardized Molecular Orientation MORc and Crystallinity]

A product of the crystallinity and the standardized molecular orientation MORc of a polymeric piezoelectric film is preferably from 40 to 700, more preferably from 75 to 680, further preferably from 90 to 660, still further preferably from 125 to 650, and particularly preferably from 150 to 350. When the above product is in the range of from 40 to 700, the balance between the piezoelectricity and the transparency of a polymeric piezoelectric film is favorable, and the dimensional stability is high, whereby the polymeric piezoelectric film can be suitably used as a piezoelectric element described below.

In a polymeric piezoelectric film according to the present embodiment, it is possible to adjust the product within the above range, for example, by adjusting the conditions of crystallization and stretching when the polymeric piezoelectric film is manufactured.

[Film Thickness]

The film thickness of a polymeric piezoelectric film is not particularly restricted, and is preferably from 10 μm to 400 μm, more preferably from 20 μm to 200 μm, further preferably from 20 μm to 100 μm, and particularly preferably from 20 μm to 80 μm. When a polymeric piezoelectric film is a multilayer film composed of a plurality of layers, the above film thickness refers to the thickness of the entire multilayer film.

The thickness of a polymeric piezoelectric film is measured by using an inline film thickness meter (also referred to as "inline thickness measurement apparatus"). As one example, in a case in which a polymeric piezoelectric film is manufactured, a method of measuring the thickness of a film while moving an inline film thickness meter in a TD direction (a direction which is perpendicular to the MD direction and which is parallel to a principal plane of the film) with respect to a film flowing in an MD direction (a direction in which a film flows) is mentioned. As an inline film thickness meter, a commercially available thickness measurement apparatus can be used, and examples thereof include a laser type non-contact inline thickness measurement apparatus NSM-RM manufactured by Yamabun Electronics Co., Ltd.

When many noises are contained in a raw data of the thickness of a film measured by an inline film thickness meter, a variety of noise removal processings may be performed on the raw data. Examples of such a processing include a moving average method and removal of a high frequency component by a Fourier transformation /inverse Fourier transformation.

One example has been mentioned for each of a method of measuring a thickness and an apparatus of measuring a thickness, but not limited thereto.

[Thickness Peak]

In a polymeric piezoelectric film of the present embodiment, the number of peaks A is 20 or less per 1,000 mm in width. The peak A refers to a peak having a peak height of 1.5 μm or more and a peak slope (that is, a value obtained by dividing the peak height by a peak-to-peak distance) of 0.000035 or more. From a viewpoint of further reducing the thickness unevenness of a polymeric piezoelectric film, the number of peaks A is preferably 15 or less, more preferably 10 or less, more preferably 8 or less, further preferably 5 or less, further preferably 3 or less, and most preferably 0.

As described above, the waviness of the film surface is presumed to be due to an abrupt change in the thickness. When the number of peaks A is within the above range, the thickness unevenness of a polymeric piezoelectric film is reduced, the appearance problem is improved, and the variation of the piezoelectricity is reduced.

From a viewpoint of further reducing the thickness unevenness of a polymeric piezoelectric film, it is preferable that the number of peaks B is 12 or less per 1000 mm in width. The peak B refers to a peak having a peak height of 1.5 μm or more and a peak slope of 0.00008 or more.

The number of peaks B is preferably 10 or less, more preferably 8 or less, further preferably 5 or less, still more preferably 3 or less, and most preferably 0, from a viewpoint of further reducing the thickness unevenness of a polymeric piezoelectric film. When the number of the peaks B is within this range, the thickness unevenness of a polymeric piezoelectric film is further reduced, the appearance problem is further improved, and in addition, the variation of the piezoelectricity is further reduced.

Here, the peak slope of a peak B is larger than the peak slope of a peak A, and the peak B is included in the peak A and measured. For example, when it is assumed that the number of peaks A is 12 and the number of peaks B is 8, it means that the number of peaks corresponding to the peaks B in the peaks A is 8.

[Measurement of Thickness Peak]

A thickness peak is determined by using an inline film thickness meter.

When the thickness of a polymeric piezoelectric film is measured, a waveform representing the relationship between a position in the width direction on the film and a thickness of the film is detected by an inline film thickness meter.

In the present embodiment, in the waveform, a portion between a position in the width direction on a film corresponding to the vertex of a convex portion and a position in the width direction on the film corresponding to the vertex of a concave portion decreasing from the vertex of the convex portion (or between the position in the width direction on a film corresponding to the vertex of a concave portion and the position in the width direction on the film corresponding to the vertex of a convex portion increasing from the vertex of the concave portion) is set as one peak unit.

A difference between the thickness corresponding to the vertex of the convex portion (or the concave portion) and the thickness corresponding to the vertex of the concave portion (or the convex portion) is measured to calculate the peak height.

A distance between a position in the width direction on the film corresponding to the vertex of a convex portion (or a concave portion) and a position in the width direction on the film corresponding to the vertex of a concave portion (or a convex portion) is measured to calculate the peak-to-peak distance. A peak slope is then calculated by the following formula, and a peak slope is expressed as an absolute value.

$$\text{[Formula]: } |\text{Peak slope}| = (\text{Peak height}) / (\text{Peak-to-peak distance})$$

Hereinafter, an example of the peak of a thickness of a polymeric piezoelectric film of the present embodiment will be described with reference to the drawing.

When the thickness of a polymeric piezoelectric film is measured with an inline film thickness meter, for example, a waveform representing the relationship between a position in the width direction on the polymeric piezoelectric film and a thickness of the polymeric piezoelectric film as shown in FIG 1 is detected.

In FIG. 1, P1 is a first peak, P2 is a second peak, P3 is a third peak, H1 is a peak height, H2 is a peak height, H3 is a peak height, L1 is a peak-to-peak distance, L2 is a peak-to-peak distance, and L3 is a peak-to-peak distance, respectively.

In the waveform illustrated in FIG. 1, the first peak P1 is a region (that is, a region surrounded by a rectangle) between a position in the width direction on the film corresponding to the vertex of a convex portion and a position in the width direction on the film corresponding to the vertex of a concave portion decreasing from the vertex of the convex portion. The second peak P2 is a region (that is, a region surrounded by a rectangle adjacent to the first peak) between a position in the width direction on the film corresponding to the vertex of a concave portion and a position in the width direction on the film corresponding to the vertex of a convex portion increasing from the vertex of the concave portion. Further, a region surrounded by a rectangle positioned on the right of the second peak P2 is the third peak P3.

Although description will be made using the first peak P1 to the third peak P3 as an example, the second peak P2 and the third peak P3 are separated for convenience of description of the peaks. However, the peaks of the present embodiment have continuous peak units over the entire position in the width direction on the film like the relationship between the first peak P1 and the second peak P2.

In the first peak P1, the peak height H1 is the difference between the thickness corresponding to the vertex of a convex portion and the thickness corresponding to the vertex of a concave portion. The peak height H3 of the third peak P3 is calculated similarly. At the second peak P2, the peak height H2 is the difference between the thickness corresponding to the vertex of a concave portion and the thickness corresponding to the vertex of a convex portion.

Here, when values of the peak height H1 to the peak height H3 are 1.5 μm or more and the peak slope described

below is within a specific range, such peaks correspond to a peak A or a peak B. On the other hand, when the values are less than 1.5 μm, such peaks do not correspond to a peak A or a peak B. For example, when the peak height H3 is less than 1.5 μm, the third peak is a peak not corresponding to any of the peak A and the peak B.

In the first peak P1, the peak-to-peak distance L1 is obtained by measuring the distance between the position in the width direction on a film corresponding to the vertex of a convex portion and the position in the width direction on the film corresponding to the vertex of a concave portion. The peak-to-peak distance L3 of the third peak P3 is calculated similarly. In the second peak P2, the peak-to-peak distance L2 is obtained by measuring the distance between the position in the width direction on the film corresponding to the vertex of a concave portion and the position in the width direction on the film corresponding to the vertex of a convex portion.

The peak slope is a value obtained by dividing the peak height by the peak-to-peak distance as described above. For example, the peak slope of the first peak P1 is calculated by the peak height H1 /peak-to-peak distance L1, and is expressed in an absolute value. The peak slope of the second peak P2 and the peak slope of the third peak P3 are similar to the above.

Here, in the first peak P1 to the third peak P3, when the peak height H1 to the peak height H3 are within the above specified ranges and the peak slope is 0.000035 or more, such peaks correspond to the peak A. When the peak height H1 to the peak height H3 are within the above specified ranges and the peak slope is 0.00008 or more, such peaks correspond to the peak B. On the other hand, even when the peak height H1 to the peak height H3 are within the above specified ranges, if the peak slope is outside these ranges, that is, if the peak slope is less than 0.000035, such peaks are peaks not corresponding to either the peak A or the peak B.

By the above method, the number of peaks corresponding to the peak A or the peak B is measured. As described above, the peak B is included in the peak A and measured.

[Method of Adjusting Thickness Peak]

A method of adjusting the thickness peak of a polymeric piezoelectric film is not particularly limited as long as the number of peaks A satisfies the above range. Examples of such a method include a method (electrostatic adhesion method) of closely contacting an extruded composition containing a helical chiral polymer (A) having a film shape on a cooling roll, a cast roll for pre-crystallization or the like by utilizing static electricity in a below-described step of manufacturing a polymeric piezoelectric film. Examples of the electrostatic adhesion method include wire pinning for bringing the entire surface of a film into close contact, and edge pinning for bringing a film into close contact only at both ends of the film, and either of the above methods may be used or both of the above methods may be used in combination.

In the case of adopting wire pinning, an electrode to which the static charge is applied may be in the form of a wire, a band, or a knife, but an electrode in the form of a wire is preferable in that the peak of the thickness can be more easily adjusted. The material of the electrode is not particularly limited as long as a static charge can be applied, but from a viewpoint of further facilitating the adjustment of the peak of the thickness, those on the surface of which is coated with gold, platinum or the like are preferable.

Although an electrostatic adhesion method is taken as an example, a method of adjusting the thickness peak is not limited thereto.

< Method of Manufacturing Polymeric Piezoelectric Film >

There is no particular restriction on the method of manufacturing a polymeric piezoelectric film of the present embodiment.

For example, a polymeric piezoelectric film of the present embodiment can be suitably manufactured by a method including a step of molding a raw material of a polymeric piezoelectric film into a film shape and a step of stretching the molded film. Examples of the manufacturing method include one described in paragraphs 0065 to 0099 of WO 2013/054918.

[Molding Step]

In a molding step, a composition containing a helical chiral polymer (A) and optional other components such as a stabilizer (B) is heated to a temperature not lower than the melting point Tm (°C) of the helical chiral polymer (A) and molded into a film shape. By this molding step, a film containing the helical chiral polymer (A) and optional other components such as the stabilizer (B) is obtained.

Herein, the melting point Tm (°C) of a helical chiral polymer (A) and the glass transition temperature (Tg) of a helical chiral polymer (A) are values respectively obtained from a melting endothermic curve obtained by raising the temperature of the helical chiral polymer (A) under the condition of a temperature increase rate of 10°C/min using a differential scanning calorimeter (DSC). The melting point (Tm) is a value obtained as a peak value of an endothermic

reaction. The glass transition temperature (Tg) is a value obtained as an inflection point of the melting endothermic curve.

The above composition can be manufactured by mixing a helical chiral polymer (A) and optional other components such as a stabilizer (B).

Here, the helical chiral polymer (A), the stabilizer (B), and the other components may be individually used singly, or two or more kinds thereof may be used.

The above mixing may be melt kneading.

Specifically, the composition may be manufactured by charging a helical chiral polymer (A) and optional other components such as a stabilizer (B) into a melt-kneader [for example, Labo Plastomill manufactured by Toyo Seiki Co., Ltd.], heating the mixture to a temperature not lower than the melting point of the helical chiral polymer (A), and melt-kneading the mixture. In this case, in this step, a composition which has been manufactured by heating to a temperature not lower than the melting point of the helical chiral polymer (A) and melt-kneading is molded into a film shape while maintaining the composition at a temperature not lower than the melting point of the helical chiral polymer (A).

Examples of conditions for melt kneading include conditions of a mixer rotation speed of 30 rpm to 70 rpm, a temperature of 180°C to 250°C, and a kneading time of 5 minutes to 20 minutes.

Examples of a method of molding a composition into a film shape in the present molding step include a known method such as an extrusion molding method.

In the molding step, a composition may be heated to the above temperature and molded into a film, and the obtained film may be quenched. By quenching, the crystallinity of the film obtained in this step can be adjusted.

Here, the term "quenching" refers to cooling to at least not higher than the glass transition temperature Tg of the helical chiral polymer (A) immediately after extrusion.

In the present embodiment, it is preferable that other processes are not included between molding into a film and quenching.

Examples of a method of quenching include: a method of immersing a film in a coolant such as water, ice water, ethanol, ethanol or methanol containing dry ice, liquid nitrogen or the like; and a method of spraying a liquid spray having a low vapor pressure onto a film and cooling the film by latent heat of vaporization.

In order to continuously cool the film, it is also possible to rapidly cool the film by contacting the film with a metal roll controlled to a temperature not higher than the glass transition temperature Tg of the helical chiral polymer (A).

The number of times of cooling may be only once or two or more times.

For example, by using an electrostatic adhesion method described above, a film obtained by an extrusion molding method is brought into close contact with a metal roll cooled by the above means, whereby the peak of the thickness of a polymeric piezoelectric film can be adjusted. For example, in the case of adopting wire pinning to bring the entire surface of a film into close contact, the peak of the thickness can be adjusted by adjusting the position of an electrode, material, applied voltage, or the like.

The film obtained in a molding step (in other words, a film to be subjected to a stretching step described below) may be an amorphous state film or a preliminarily crystallized film (hereinafter, also referred to as a "pre-crystallized film").

Here, the amorphous state film means a film having a crystallinity of less than 3%.

The pre-crystallized film means a film having a crystallinity of 3% or more (preferably from 3% to 70%).

Here, the crystallinity refers to a value measured by a method similar to the crystallinity of a polymeric piezoelectric film.

The thickness of a film (amorphous state film or pre-crystallized film) obtained in the molding step is mainly determined according to the thickness of the polymeric piezoelectric film finally obtained and the stretching ratio, but is preferably from 50 μm to 1,000 μm, and more preferably about from 100 μm to 800 μm.

The pre-crystallized film can be obtained by heat-treating an amorphous state film containing a helical chiral polymer (A) and optional other components such as a stabilizer (B) to be crystallized.

The heating temperature T for preliminarily crystallizing an amorphous state film is not particularly limited, but from a viewpoint of enhancing the piezoelectricity and transparency of a polymeric piezoelectric film to be manufactured, it is preferable that the heating temperature T is set such that the heating temperature T and the glass transition temperature Tg of a helical chiral polymer (A) satisfies the relationship of the following formula, and the crystallinity is from 3% to 70%.

$$Tg - 40°C \leq T \leq Tg + 40°C$$

(Tg represents the glass transition temperature of the helical chiral polymer (A))

The heating time for preliminarily crystallizing an amorphous state film can be appropriately set in consideration of the standardized molecular orientation MORc and the crystallinity of an ultimately obtained polymeric piezoelectric film.

The heating time is preferably from 5 seconds to 60 minutes, and more preferably from 1 minute to 30 minutes

from a viewpoint of stabilizing the manufacturing conditions. As the heating time becomes longer, the standardized molecular orientation MORc becomes higher and the crystallinity tends to become higher.

For example, in the case of preliminarily crystallizing an amorphous state film containing a polylactic acid-based polymer as the helical chiral polymer (A), it is preferable to perform heating at from 20°C to 170°C for 5 seconds to 60 minutes (preferably from 1 minute to 30 minutes).

In order to preliminarily crystallize an amorphous state film, for example, a cast roll adjusted to the above temperature range can be used. By using the electrostatic adhesion method described above, the polymeric piezoelectric film is brought into close contact with a cast roll for preliminary crystallization, whereby it is possible to preliminarily crystallize and adjust the peak of the thickness. For example, in the case of adopting wire pinning to bring the entire surface of the film into close contact, the peak of the thickness can be adjusted by adjusting the position of the electrode, material, applied voltage, and the like.

[Stretching Process]

The stretching step is a step of stretching a film (for example, a pre-crystallized film) obtained in the molding step mainly in the uniaxial direction. By this step, a polymeric piezoelectric film having a large principal plane area can be obtained as a stretched film.

"The principal plane area is large" means that the area of the principal plane of a polymeric piezoelectric film is 5 $mm^2$ or more. The area of the principal plane is preferably 10 $mm^2$ or more.

It is presumed that, by stretching the film mainly in the uniaxial direction, molecular chains of a helical chiral polymer (A) contained in the film can be orientated in one direction and aligned at high density, thereby obtaining higher piezoelectricity.

In the case of stretching a film only by a tensile force such as by stretching in the uniaxial direction, the stretching temperature of the film is preferably in the range of about from 10°C to 20°C higher than the glass transition temperature of the film (or a helical chiral polymer (A) in the film).

The stretching ratio in the stretching treatment is preferably from 2 to 30 times, more preferably from 3 to 15 times.

When a pre-crystallized film is stretched in a stretching step, the film may be preheated immediately before stretching so that the film can be easily stretched. Since the preheating is performed generally for the purpose of softening the film before stretching in order to facilitate the stretching, the preheating is normally performed under the conditions of not crystallizing and hardening the film before stretching. Meanwhile, as described above, in the present embodiment, pre-crystallization may be performed before stretching, and therefore the preheating may be performed combined with the pre-crystallization. Specifically, by conducting the preheating at a higher temperature than a temperature normally used, or for longer time, conforming to the heating temperature or the heat treatment time at the pre-crystallization step, preheating and pre-crystallization can be combined.

[Annealing Step]

The manufacturing method of this embodiment may optionally include an annealing step.

The annealing step is a step of annealing (heat-treating) a film (hereinafter also referred to as "stretched film") stretched in the stretching step. By the annealing step, crystallization of the stretched film can be further advanced, and a polymeric piezoelectric film having higher piezoelectricity can be obtained.

When the stretched film is crystallized mainly by annealing, the preliminary crystallization operation in the above molding step may be omitted. In this case, an amorphous state film can be selected as a film (that is, a film to be subjected to a stretching step) obtained in the molding step.

In the present embodiment, the annealing temperature is preferably from 80°C to 160°C, and more preferably from 100°C to 155°C.

A method of annealing (heat treatment) is not particularly limited, and examples thereof include: a method in which a stretched film is directly heated by being in contact with a heating roll, or using a hot air heater or an infrared heater; and a method in which a stretched film is heated by being immersed in a heated liquid (silicone oil or the like).

Annealing is preferably performed while applying a fixed tensile stress (for example, from 0.01 MPa to 100 MPa) to the stretched film in such a manner that the stretched film does not sag.

The annealing time is preferably from 1 second to 5 minutes, more preferably from 5 seconds to 3 minutes, and still more preferably from 10 seconds to 2 minutes. When the annealing time is 5 minutes or less, excellent productivity is obtained. On the other hand, when the annealing time is 1 second or more, the crystallinity of the film can be further improved.

An annealed stretched film (that is, a polymeric piezoelectric film) is preferably quenched after annealing. "Quenching" which may be carried out in the annealing step is similar to "quenching" which may be carried out in the above molding step.

The number of times of cooling may be once, or twice or more times, and it is also possible to alternately repeat annealing and cooling.

< Use or the Like of Polymeric Piezoelectric Film >

A polymeric piezoelectric film of the present embodiment can be used in a variety of fields including a speaker, a headphone, a touch panel, a remote controller, a microphone, a hydrophone, an ultrasonic transducer, an ultrasonic applied measurement instrument, a piezoelectric vibrator, a mechanical filter, a piezoelectric transformer, a delay unit, a sensor, an acceleration sensor, an impact sensor, a vibration sensor, a pressure-sensitive sensor, a tactile sensor, an electric field sensor, a sound pressure sensor, a display, a fan, a pump, a variable-focus mirror, a sound insulation material, a soundproof material, a keyboard, acoustic equipment, information processing equipment, measurement equipment, and a medical appliance.

In this case, a polymeric piezoelectric film according to the present embodiment is preferably used as a piezoelectric element having at least two principal planes provided with electrodes. It is enough if the electrodes are provided on at least two planes of the polymeric piezoelectric film. There is no particular restriction on the electrode, and examples thereof to be used include ITO, ZnO, IGZO, and an electroconductive polymer.

A polymeric piezoelectric film and an electrode may be piled up one another and used as a layered piezoelectric element. For example, units of an electrode and a polymeric piezoelectric film are piled up repeatedly and finally a principal plane of a polymeric piezoelectric film not covered by an electrode is covered by an electrode. Specifically, that with two repeating units is a layered piezoelectric element having an electrode, a polymeric piezoelectric film, an electrode, a polymeric piezoelectric film, and an electrode layered in this order. With respect to polymeric piezoelectric films to be used for a layered piezoelectric element, at least one layer of the polymeric piezoelectric films is a polymeric piezoelectric film according to the present embodiment, and other layers may not be polymeric piezoelectric films according to the present embodiment.

In a case in which a plurality of polymeric piezoelectric films according to the present embodiment are included in a layered piezoelectric element, when a helical chiral polymer (A) contained in one polymeric piezoelectric film layer according to the present embodiment has L-form optical activity, a helical chiral polymer (A) contained in another polymeric piezoelectric film layer may be either of L-form or D-form. The location of polymeric piezoelectric films may be adjusted appropriately according to use of a piezoelectric element.

For example, when the first layer of a polymeric piezoelectric film containing as a main component an L-form helical chiral polymer (A) is layered via an electrode with the second polymeric piezoelectric film containing as a main component an L-form helical chiral polymer (A), if the uniaxial stretching direction (main stretching direction) of the first polymeric piezoelectric film crosses, preferably perpendicularly crosses, the uniaxial stretching direction (main stretching direction) of the second polymeric piezoelectric film, the displacement directions of the first polymeric piezoelectric film and the second polymeric piezoelectric film can become the same, and the piezoelectricity of the layered piezoelectric element as a whole can be favorably enhanced.

On the other hand, when the first layer of a polymeric piezoelectric film containing as a main component an L-form helical chiral polymer (A) is layered via an electrode with the second polymeric piezoelectric film containing as a main component a D-form helical chiral polymer (A), if the uniaxial stretching direction (main stretching direction) of the first polymeric piezoelectric film is arranged nearly parallel to the uniaxial stretching direction (main stretching direction) of the second polymeric piezoelectric film, the displacement directions of the first polymeric piezoelectric film and the second polymeric piezoelectric film can become the same, and the piezoelectricity of the layered piezoelectric element as a whole can be favorably enhanced.

Especially, when a principal plane of a polymeric piezoelectric film is provided with an electrode, it is preferable to provide a transparent electrode. In this regard, with respect to an electrode, "transparent" means specifically that the internal haze is 20% or less and the total luminous transmittance is 80% or more.

The piezoelectric element using a polymeric piezoelectric film of the present embodiment may be applied to the aforementioned various piezoelectric devices including a speaker and a touch panel. A piezoelectric element provided with a transparent electrode is favorable for applications, such as a speaker, a touch panel, and an actuator.

## EXAMPLES

The embodiment of the present invention will be described below in more details by way of Examples, provided that the present embodiment is not limited to the following Examples to the extent not to depart from the spirit of the embodiment.

< Example 1>

A polylactic acid (Ingeo 4032D) manufactured by NatureWorks LLC was prepared as a raw material (a helical chiral polymer (A)). To 100 parts by mass of the raw material, 1.0 part by mass of the additive X (stabilizer (B)) below was added and dry blended to prepare a raw material.

The manufactured raw material was placed in an extruder hopper and extruded from a T die having a width of 2,000 mm while being heated to 220°C to 230°C, and brought into contact with a cast roll at 50°C for 0.5 minutes to obtain a pre-crystallized film having a thickness of 150 μm (molding step).

At this time, a wire electrode (tungsten wire, φ = 0.15 mm) was arranged in the vicinity of the contact point of the helical chiral polymer extruded from the T die and the cast roll so that the wire electrode, the helical chiral polymer (A), and the cast roll were arranged in this order. Setting the tension of the wire electrode to 15 N, the applied voltage to 7 kV, and the distance between the wire electrode and the contact point of the helical chiral polymer (A) and the cast roll to 60 mm, a static charge was applied from the helical chiral polymer (A) side toward the cast roll, so that the helical chiral polymer (A) was brought into close contact with the cast roll.

While the obtained pre-crystallized film was brought into contact with a roll heated to 70°C and was heated, stretching was started at a stretching speed of 1,650 mm/min by roll-to-roll, and the film was uniaxially stretched in the MD direction up to 3.5 times, thereby obtaining a uniaxially stretched film (stretching step).

Thereafter, the uniaxially stretched film was brought into contact with a roll heated to 130°C for 78 seconds, annealed, then quenched with a roll set at 50°C, evenly slit at both ends in the film width direction and cut off to obtain a film having a width of 1,000 mm, and further, wound up in a roll shape to obtain a film-shaped polymeric piezoelectric film (annealing step).

- Additive X (Stabilizer (B)) -

As the additive X, a mixture of Stabaxol P400 (10 parts by mass) manufactured by Rhein Chemie GmbH, Stabaxol I (60 parts by mass) manufactured by Rhein Chemie GmbH, and CARBODILITE LA-1 (30 parts by mass) manufactured by Nisshinbo Chemical Inc. was used.

Details of the components in the above mixture are as follows.

Stabaxol I ... bis-2,6-diisopropylphenyl carbodiimide (molecular weight (= weight average molecular weight): 363)
Stabaxol P400 ... poly(1,3,5-triisopropylphenylene-2,4-carbodiimide) (weight average molecular weight: 20,000)
Carbodilite LA-1 ... poly(4,4'-dicyclohexylmethane carbodiimide) (weight average molecular weight: about 2,000)

< Comparative Example 1 >

A polymeric piezoelectric film was obtained in a similar manner to Example 1 except that the distance between the wire electrode and the contact point of the helical chiral polymer (A) and the cast roll was set at 45 mm.

< Example 2 >

A polymeric piezoelectric film was obtained in a similar manner to Example 1 except that the distance between the wire electrode and the contact point of the helical chiral polymer (A) and the cast roll was set at 75 mm.

< Example 3 >

A polymeric piezoelectric film was obtained in a similar manner to Example 2 except that the wire electrode was changed to a platinum coated tungsten wire (φ = 0.15 mm).

[Measurement of Physical Properties of Helical Chiral Polymer (A)]

The optical purity of the helical chiral polymer (A) was measured by the following method. The weight average molecular weight and molecular weight distribution were also measured by the method described above. The results are listed in Table 1.

(Optical Purity)

The optical purity of the helical chiral polymer (A) (polylactic acid) contained in the polymeric piezoelectric film was measured as follows.

Into a 50 mL Erlenmeyer flask, 1.0 g of a weighed-out sample (the above polymeric piezoelectric film) was charged, to which 2.5mL of IPA (isopropyl alcohol) and 5 mL of a 5.0 mol/L sodium hydroxide solution were added, thereby obtaining a sample solution.

The Erlenmeyer flask containing the sample solution was then placed in a water bath at the temperature of 40°C, and stirred for about 5 hours until polylactic acid was completely hydrolyzed.

After the stirring for approximately 5 hours, the sample solution was cooled to room temperature, then neutralized by adding 20 mL of a 1.0 mol/L hydrochloric acid solution, and the Erlenmeyer flask was sealed tightly and stirred well.

Next, 1.0 mL of the above-stirred sample solution was taken in a 25 mL volumetric flask, and a mobile phase having the following composition was added thereto to obtain 25 mL of HPLC sample solution 1.

5 μL of the obtained HPLC sample solution 1 was injected into the HPLC apparatus, and HPLC measurement was performed under the following HPLC measurement conditions. From the measurement results obtained, the area of the peak derived from the D-form of the polylactic acid and the area of the peak derived from the L-form of the polylactic acid were determined, and the amount of the L-form and the amount of the D-form were calculated. Based on the obtained results, the optical purity (% ee) was determined.

As a result, the optical purity was 97.0% ee. In the following Table 1, "LA" represents polylactic acid.

- HPLC Measurement Condition -

- Column: Optical resolution column, SUMICHIRAL OA5000 (manufactured by Sumika Chemical Analysis Service, Ltd.)
- HPLC apparatus: Liquid chromatography (manufactured by Jasco Corporation)
- Column temperature: 25°C
- Composition of mobile phase: 1.0 mM-copper (II) sulfate buffer solution/IPA = 98/2 (VN) (In this mobile phase, the ratio of copper (II) sulfate, IPA, and water is Copper (II) sulfate/IPA/water = 156.4 mg/20 mL/980 mL)
- Mobile phase flow rate: 1.0 mL/min
- Detector: Ultraviolet detector (UV 254 nm)

Table 1

| Helical chiral polymer (A) | | | | |
|---|---|---|---|---|
| Resin | Chirality | Mw | Mw/Mn | Optical purity (%ee) |
| LA | L | 200,000 | 1.83 | 97.0 |

[Measurement of Physical Properties of Polymeric Piezoelectric Film]

With respect to the polymeric piezoelectric film, the crystallinity, internal haze, thickness, and peaks of the thickness were measured by the following methods. The piezoelectric constant (stress-electric charge method) and the standardized molecular orientation MORc were also measured by the methods described above. The results are listed in Table 2.

For the piezoelectric constant, the difference R was determined from the maximum value and the minimum value in the measurement data. The standard deviation σ of the piezoelectric constant was obtained from the average value of the piezoelectric constant.

(Crystallinity)

Each 10 mg of respective polymeric piezoelectric films was weighed accurately and measured by a differential scanning calorimeter (DSC-1, manufactured by Perkin Elmer Co., Ltd.) at a temperature increase rate of 10°C/min to obtain a melting endothermic curve. From the obtained melting endothermic curve, the crystallinity was obtained.

(Internal Haze)

Internal haze (hereinafter, also referred to as internal haze (H1)) of the polymeric piezoelectric film was obtained by the following method.

First, a layered film sandwiching only silicone oil ("Shin-Etsu Silicone, model number: KF96-100CS" manufactured by Shin-Etsu Chemical Co., Ltd.) between two glass plates was prepared, and the haze (hereinafter, referred to as haze (H2)) in the thickness direction of the layered film was measured.

Next, a layered film obtained by sandwiching the polymeric piezoelectric film having surfaces uniformly coated with silicone oil between the above two glass plates was prepared and the haze (hereinafter, referred to as haze (H3) in the thickness direction of the layered film was measured.

The internal haze (H1) of the polymeric piezoelectric film was obtained by taking the difference between them as described in the following formula.

$$\text{Internal haze (H1)} = \text{haze (H3)} - \text{haze (H2)}$$

Here, measurements of the haze (H2) and haze (H3) were performed by using the following apparatus under the following measuring conditions.

Measuring apparatus: HAZE METER TC-HIIIDPK, manufactured by Tokyo Denshoku Co., Ltd.
Sample size: Width 30 mm × length 30 mm
Measuring conditions: According to JIS-K7105
Measuring temperature: Room temperature (25°C)

(Thickness Measurement)

During the manufacturing of a film, at the position set after the annealing step where the thickness can be measured, the thickness of the film was measured under the conditions of a sampling pitch of 1 mm, a measurement width of 1000 mm, a resolution of 0.2 μm, a sensor running speed of 60 mm/s, and a moving average of 20 times as noise removal processing, using a laser type non-contact inline film thickness meter (NSM-RM, manufactured by Yamabun Electronics Co., Ltd.). From the thickness maximum value $T_{max}$ (μm) and the minimum value $T_{min}$ (μm) in the measurement data, the thickness difference R was obtained based on the following Formula 1.

$$[\text{Formula 1}] \cdot\cdot\ R\ (\mu m) = T_{max} - T_{min}$$

Further, from the thickness R and the average thickness value $T_{Ave}$ (μm), the thickness unevenness R% was obtained based on the following Formula 2, and the standard deviation σ of the thickness of the film was obtained.

$$[\text{Formula 2}] \cdot\cdot\ R\% = (R/T_{Ave}) \times 100$$

(Measurement of the numbers of peaks A and peaks B)

From the waveform representing the relationship between the position in the width direction on the polymeric piezoelectric film and the thickness of the polymeric piezoelectric film obtained by measuring the thickness by the inline film thickness meter, the numbers of the peaks A and the peaks B were obtained by the above described method.

Peak A: Peak height was 1.5 μm or more, and the peak slope was 0.000035 or more.
Peak B: Peak height was 1.5 μm or more, and the peak slope was 0.00008 or more.

(Appearance)

The polymeric piezoelectric film was visually observed and observed under cross-Nicol, and the appearance was evaluated according to the following criteria.

Visual observation

A: No distortion was observed in the transmission image of the film.
B: Almost no distortion was observed in the transmission image of the film.

C: Distortion was observed in the transmission image of the film.

Under cross-Nicol

A: Color unevenness corresponding to phase difference unevenness was hardly observed.
B: Color unevenness corresponding to phase difference unevenness was not observed much.
C: Color unevenness corresponding to phase difference unevenness was observed.

Table 2

| | Thickness | | | | Peak A | Peak B | Piezoelectric constant $d_{14}$ | | | Internal haze | Crystallinity | MORc | MORc × crystallinity | Appearance | |
|---|---|---|---|---|---|---|---|---|---|---|---|---|---|---|---|
| | $T_{Ave}$ | R | R% | σ | | | Ave | R | σ | | | | | Visually | Under cross-Nicol |
| | [μm] | [μm] | [%] | [μm] | [/1000 mm] | [/1000 mm] | [pC/N] | [pC/N] | [pC/N] | (%) | (%) | | | | |
| Example 1 | 50.4 | 5.1 | 10 | 1.5 | 14 | 6 | 6.419 | 0.137 | 0.041 | 0.3 | 38.8 | 4.43 | 172 | B | B |
| Example 2 | 49.9 | 6.8 | 14 | 1.4 | 10 | 2 | 6.471 | 0.105 | 0.036 | 0.3 | 39.2 | 4.35 | 171 | A | A |
| Example 3 | 50.1 | 3 | 6 | 0.7 | 8 | 4 | 6.117 | 0.18 | 0.06 | 0.2 | 36.7 | 4.31 | 158 | A | A |
| Comparative Example 1 | 50.9 | 5.6 | 11 | 1.3 | 24 | 16 | 6.256 | 0.387 | 0.1 | 0.3 | 37.3 | 4.38 | 163 | C | C |

As shown in Table 2, it is found that in each of the Examples in which the number of Peaks A is 20 or less, the variation in the thickness is reduced as compared with Comparative Example 1 in which the number of Peaks A exceeds 20.

The difference R between the maximum value and the minimum value of the piezoelectric constant and the value of the standard deviation $\sigma$ of the piezoelectric constant in each of the Examples are smaller than the respective numerical values of the piezoelectric constant in Comparative Example 1. As a result, it is found that in each of the Examples, the variation in the piezoelectric constant is reduced as compared with the Comparative Example 1.

Further, the thickness difference R, thickness variation R%, and thickness standard deviation $\sigma$ in Examples 1 and 2 are about the same as those in Comparative Example 1. However, the variation of the piezoelectric constant in Examples 1 and 2 is reduced as compared with Comparative Example 1. From this, it is found that even when the film is manufactured in such a manner that the average information (R, R%, $\sigma$) of the entire thickness becomes small, it may be difficult to reduce the variation in the piezoelectric constant. Similarly, the appearance in Examples 1 and 2 is superior to that of Comparative Example 1. Therefore, it is found that even when the film is manufactured in such a manner that the average information (R, R%, $\sigma$) of the entire thickness is reduced, it may be difficult to improve the appearance.

The disclosure of Japanese Patent Application No. 2014-231857, filed November 14, 2014, is incorporated herein by reference in its entirety.

All publications, patent applications, and technical standards mentioned in this specification are herein incorporated by reference to the same extent as if each individual publication, patent application, or technical standard was specifically and individually indicated to be incorporated by reference.

## Claims

1. A polymeric piezoelectric film comprising an optically active helical chiral polymer (A) having a weight average molecular weight of from 50,000 to 1,000,000, wherein:

   a crystallinity obtained by a DSC method is from 20% to 80%;
   a standardized molecular orientation MORc measured by a microwave transmission-type molecular orientation meter based on a reference thickness of 50 $\mu$m is from 3.5 to 15.0; and
   in a waveform measured with an inline film thickness meter and representing a relationship between a position in a width direction on the film and a thickness of the film, a number of peaks A is 20 or less per 1,000 mm of a film width, wherein the peaks A have a peak height of 1.5 $\mu$m or more and a peak slope of 0.000035 or more.

2. The polymeric piezoelectric film according to claim 1, wherein in the waveform measured with the inline film thickness meter and representing the relationship between a position in the width direction on the film and a thickness of the film, a number of peaks B is 12 or less per 1,000 mm of the film width, wherein the peaks B have a peak height of 1.5 $\mu$m or more and a peak slope of 0.00008 or more.

3. The polymeric piezoelectric film according to claim 1 or 2, wherein an internal haze with respect to visible light is 50% or less, and a piezoelectric constant $d_{14}$ measured by a stress-electric charge method at 25°C is 1 pC/N or more.

4. The polymeric piezoelectric film according to any one of claims 1 to 3, wherein an internal haze with respect to visible light is 13% or less.

5. The polymeric piezoelectric film according to any one of claims 1 to 4, wherein the helical chiral polymer (A) is a polylactic acid-based polymer having a main chain comprising a repeating unit represented by the following Formula (1):

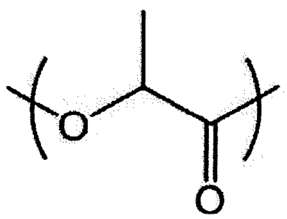

(1)

6. The polymeric piezoelectric film according to any one of claims 1 to 5, wherein a content of the helical chiral polymer (A) is 80% by mass or more.

7. The polymeric piezoelectric film according to any one of claims 1 to 6, wherein a product of the standardized molecular orientation MORc and the crystallinity is from 40 to 700.

8. The polymeric piezoelectric film according to any one of claims 1 to 7, wherein an internal haze with respect to visible light is 1.0% or less.

9. The polymeric piezoelectric film according to any one of claims 1 to 8, comprising from 0.01 parts by mass to 10 parts by mass of a stabilizer (B) with respect to 100 parts by mass of the helical chiral polymer (A), the stabilizer (B) having a weight average molecular weight of from 200 to 60,000 and having one or more functional groups selected from the group consisting of a carbodiimide group, an epoxy group, and an isocyanate group.

10. The polymeric piezoelectric film according to any one of claims 1 to 9, wherein the number of the peaks A is 15 or less per 1,000 mm of the film width.

11. The polymeric piezoelectric film according to any one of claims 1 to 10, wherein the number of the peaks A is 10 or less per 1,000 mm of the film width.

12. The polymeric piezoelectric film according to any one of claims 1 to 11, wherein the number of the peaks B is 10 or less per 1,000 mm of the film width.

13. The polymeric piezoelectric film according to any one of claims 1 to 12, wherein the number of the peaks B is eight or less per 1,000 mm of the film width.

FIG.1

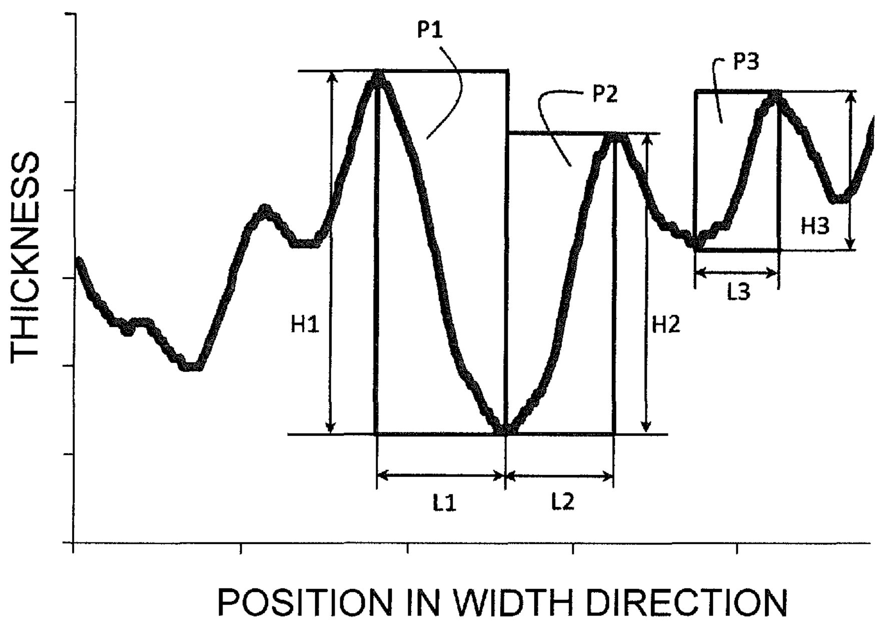
P1
P2
P3
THICKNESS
H1
H2
H3
L1
L2
L3
POSITION IN WIDTH DIRECTION

## INTERNATIONAL SEARCH REPORT

International application No.
PCT/JP2015/079338

A. CLASSIFICATION OF SUBJECT MATTER
*H01L41/193*(2006.01)i, *B29C55/04*(2006.01)i, *H01L41/083*(2006.01)i, *H01L41/27*(2013.01)i, *H01L41/45*(2013.01)i

According to International Patent Classification (IPC) or to both national classification and IPC

B. FIELDS SEARCHED

Minimum documentation searched (classification system followed by classification symbols)
H01L41/193, B29C55/04, H01L41/083, H01L41/27, H01L41/45

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2015 |
| Kokai Jitsuyo Shinan Koho | 1971-2015 | Toroku Jitsuyo Shinan Koho | 1994-2015 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2014-093487 A (Mitsui Chemicals, Inc.), 19 May 2014 (19.05.2014), entire text; all drawings (Family: none) | 1-13 |
| A | JP 2001-191407 A (Mitsubishi Plastics, Inc.), 17 July 2001 (17.07.2001), entire text; all drawings (Family: none) | 1-13 |
| A | JP 2009-073982 A (Sumitomo Chemical Co., Ltd.), 09 April 2009 (09.04.2009), entire text; all drawings (Family: none) | 1-13 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 17 December 2015 (17.12.15) | 12 January 2016 (12.01.16) |

| Name and mailing address of the ISA/ | Authorized officer |
|---|---|
| Japan Patent Office<br>3-4-3,Kasumigaseki,Chiyoda-ku,<br>Tokyo 100-8915,Japan | <br><br>Telephone No. |

Form PCT/ISA/210 (second sheet) (July 2009)

INTERNATIONAL SEARCH REPORT

International application No. PCT/JP2015/079338

C (Continuation). DOCUMENTS CONSIDERED TO BE RELEVANT

| Category* | Citation of document, with indication, where appropriate, of the relevant passages | Relevant to claim No. |
|---|---|---|
| A | JP 2010-234715 A (Konica Minolta Opto, Inc.), 21 October 2010 (21.10.2010), entire text; all drawings (Family: none) | 1-13 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP H05152638 A
- JP 2005213376 A
- JP 2014086703 A
- JP 2014027055 A
- JP S59096123 A
- JP H07033861 A
- US 2668182 A
- US 4057357 A
- WO 2013054918 A
- US 2941956 A
- JP S4733279 B
- JP 4084953 B
- JP 2011256337 A
- JP 2014231857 A


### Non-patent literature cited in the description


- *J. Org. Chem.,* 1963, vol. 28, 2069-2075
- *Chemical Review,* 1981, vol. 81 (4), 619-621